# EUROPEAN PATENT SPECIFICATION

(11) **EP 3 660 894 B1**
(45) Date of publication and mention of the grant of the patent: **15.01.2025**
(21) Application number: 18839408.4
(22) Date of filing: 29.06.2018
(51) Int. Cl.: H01L 23/367, H01L 23/373, C04B 37/00

(54) **HEAT DISSIPATION ELEMENT AND PREPARATION METHOD THEREFOR, AND IGBT MODULE**
WÄRMEABLEITUNGSELEMENT UND VERFAHREN ZU DESSEN HERSTELLUNG SOWIE IGBT-MODUL
ÉLÉMENT DE DISSIPATION DE CHALEUR ET SON PROCÉDÉ DE PRÉPARATION, ET MODULE IGBT

(30) Priority: 27.07.2017 CN 201710626333
(43) Date of publication of application: 03.06.2020
(73) Proprietor: BYD Company Limited, Shenzhen, Guangdong 518118 (CN)
(72) Inventor: GONG, Qing, Shenzhen Guangdong 518118 (CN); LIN, Xinping, Shenzhen Guangdong 518118 (CN); XU, Qiang, Shenzhen Guangdong 518118 (CN); LIU, Chengchen, Shenzhen Guangdong 518118 (CN)
(74) Representative: Gulde & Partner
(86) International application number: PCT/CN2018/093610
(87) International publication number: WO 2019/019857

(56) References cited:
- EP-A2- 1 770 773
- WO-A1-2008/123172
- WO-A2-2007/016649
- CN-A- 1 929 119
- CN-A- 106 946 583
- CN-A- 107 546 200
- CN-U- 205 414 362
- CN-U- 205 464 280
- CN-U- 207 097 805
- JP-A- 2003 078 086
- JP-A- 2011 189 354
- JP-A- 2011 189 354
- JP-A- 2012 195 467
- JP-A- 2013 225 686

## Description

### FIELD

The present disclosure relates to the technical field of heat sinks, and in particular, to a heat dissipation element, a method for manufacturing the heat dissipation element, and an IGBT module.

### BACKGROUND

An insulated gate bipolar transistor (IGBT) is a composite full-controlled voltage-driven power semiconductor device including a bipolar transistor and an insulated gate field effect transistor, and is widely applied to various electronic devices. With the development of high-current electronic devices such as a converter, higher requirements are put forward on performance of an IGBT chip. The IGBT chip bears a higher current, and heat generated during operating of the IGBT chip continuously increases. Current direct packaging of the IGBT chip uses a vacuum welding technology. A packaging process totally includes three processes: manufacturing of an aluminum-clad ceramic heat conductor, processing on silicon carbide heat dissipation body, and welding between the aluminum-clad ceramic heat conductor and the silicon carbide heat dissipation body. The vacuum welding technology is complex and has a long production period. Moreover, bubbles generated in a welding process or an uneven solder layer may result in that voids having different shapes and sizes are formed at a welding layer. The voids in the welding layer may cause a current density effect, resulting in thermoelectric breakdown, poor heat conduction, and the like. Consequently, a packaging yield rate thereof decreases, and a service life is shortened.

WO 2008/123172 A1 relates to a heat spreader module, a heat sink, and a manufacturing method thereof. JP 2003 078086 A relates to an improvement of a semiconductor element module substrate, and more particularly, to improving the inter-layer compatibility in the respective laminated structures of a circuit board and a heat sink member, increasing the bonding strength, and improving the circuit strength. WO 2007/016649 A2 relates to power semiconductors and particularly to a highly-reliable package for wide band gap power devices such as silicon carbide (SiC) power device applications and/or combined SiC and silicon power device applications. EP 1 770 773 A2 relates to a heat spreader module for cooling an IC chip used in semiconductor devices or the like, and to a method of manufacturing such a heat spreader module.

Therefore, a new heat dissipation apparatus is urgently required to overcome the defects of vacuum welding in the prior art, to obtain a heat dissipation apparatus having a better heat conduction effect.

### SUMMARY

An objective of the present disclosure is to provide a heat dissipation element. The heat dissipation element has a good heat conduction effect, a simple structure, and a low processing difficulty.

To achieve the foregoing objective, the present disclosure provides a heat dissipation element. The heat dissipation element includes a heat conductor and a heat dissipation body; where the heat conductor is an aluminum-clad ceramic heat conductor; the heat dissipation body is an aluminum silicon carbon heat dissipation body; the aluminum silicon carbon heat dissipation body is provided with one or more grooves; and the aluminum-clad ceramic heat conductor is embedded into the groove through aluminizing in an integral forming manner. The aluminum-clad ceramic heat conductor comprises a ceramic insulating plate, and a first aluminum layer and a second aluminum layer that are integrally formed through aluminizing on two opposite surfaces of the ceramic insulating plate, and the first aluminum layer is adjacent to the aluminum silicon carbon heat dissipation body and is bonded to the aluminum silicon carbon heat dissipation body, wherein a thickness of the first aluminum layer is 0.02 to 0.15 mm, a thickness of the ceramic insulating plate is 0.25 to 1 mm, and a thickness of the second aluminum layer is 0.2 to 1.0 mm.

In the foregoing technical solution, compared with a heat dissipation element obtained through vacuum welding, the heat dissipation element described in the present disclosure has fewer voids at a metal layer, higher strength, and a higher yield rate, and a service life is extended; the heat dissipation element has a thinner aluminum layer, thereby improving heat conduction efficiency of the heat dissipation element; there is no gap on bonding surfaces between layers of the heat dissipation element provided in the present disclosure, thereby having higher connection strength and higher heat conduction efficiency; in addition, a relatively soft aluminum-clad ceramic cover layer provides the heat dissipation apparatus with more excellent performance in coldness and heat impact tolerance; moreover, the present disclosure uses the foregoing aluminum silicon carbon heat dissipation body provided with a groove, and the aluminum-clad ceramic heat conductor is embedded into the groove through aluminizing in an integral forming manner, thereby avoiding a case in which an edge of a pasted film cracks during etching to affect an etching pattern, improving accuracy of etching, and improving strength and stability of the heat dissipation element.

The present disclosure further provides a method for manufacturing a heat dissipation element. The method includes the following steps:

S1. Mount a silicon carbide porous skeleton and a ceramic insulating plate into an aluminizing mold, the silicon carbide porous skeleton being provided with at least one groove, the ceramic insulating plate being placed inside the groove, and enabling a first slot to exist between a groove bottom of the silicon carbide porous skeleton and the ceramic insulating plate, and a second slot to exist between the ceramic insulating plate and a wall of the aluminizing mold.

S2. Under pressure casting infiltration conditions, add molten aluminum liquid into the preheated aluminizing mold, and filling the first slot, the second slot and the silicon carbide porous skeleton (11) with the molten aluminum liquid, perform operations of vacuum pumping and pressurizing, and then perform cooling and demolding.

S3. Form an aluminum silicon carbon heat dissipation body after the interior of the silicon carbide porous skeleton is filled with aluminum, and remove a part of aluminum metal in the second slot by etching, to enable remaining aluminum metal in the second slot to form a second aluminum layer; and the second aluminum layer and a first aluminum layer being isolated by the ceramic insulating plate, and the second aluminum layer being isolated from the aluminum silicon carbon heat dissipation body, wherein a thickness of the first aluminum layer is 0.02 to 0.15 mm, a thickness of the ceramic insulating plate is 0.25 to 1 mm, and a thickness of the second aluminum layer is 0.2 to 1 mm.

In the foregoing technical solution, according to the method for manufacturing the heat dissipation element provided in the present disclosure, molten aluminum liquid or aluminum alloy liquid is integrally formed to produce an aluminum-clad ceramic heat conductor, and the aluminum-clad ceramic heat conductor is connected to a heat dissipation body. Three steps in a vacuum welding technology including manufacturing of the aluminum-clad ceramic heat conductor, processing on the heat dissipation body, and welding between the aluminum-clad ceramic heat conductor and the heat dissipation body are combined into one step, thereby shortening a production period of the heat dissipation element; moreover, the ceramic insulating plate is placed inside a groove of the aluminum silicon carbon heat dissipation body, so that it is easy to control a thickness of an aluminum layer on the surface of the aluminum-clad ceramic heat conductor, and the step simplifies the manufacturing process of the heat dissipation element.

The present disclosure further provides a heat dissipation element manufactured by using the foregoing method.

The present disclosure further provides an IGBT module. The IGBT module includes an IGBT circuit board and the heat dissipation element described above.

Other features and advantages of the present disclosure are described in detail in subsequent specific implementations.

### BRIEF DESCRIPTION OF THE DRAWINGS

The accompanying drawings are used to provide a further understanding of the present disclosure, and constitute a part of the specification. The accompanying drawings are used, along with the following specific implementations, to explain the present disclosure, but do not constitute any limitation on the present disclosure. In the drawings:
FIG. 1 is a sectional view of a structure of a heat dissipation element;
FIG. 2 is a sectional view of an aluminizing mold and an inner structure of the aluminizing mold; and
FIG. 3 is a top view of a heat dissipation element.

### Reference numerals:

| | | | |
|---|---|---|---|
| 1 | Aluminum silicon carbon heat dissipation body | 2 | Ceramic insulating plate |
| 3 | First aluminum layer | 4 | Second aluminum layer |
| 5 | Heat dissipation column | 6 | Groove |
| 7 | First slot | 8 | Second slot |
| 9 | Third slot | 10 | Aluminizing mold |
| 11 | Silicon carbide porous skeleton | | |

### DETAILED DESCRIPTION

The following describes specific implementations of the present disclosure in detail with reference to the accompanying drawings. It should be understood that the specific implementations described herein are merely used to describe and explain the present disclosure, but are not intended to limit the present disclosure.

A first aspect of the present disclosure provides a heat dissipation element. The heat dissipation element includes a heat conductor and a heat dissipation body, where the heat conductor is an aluminum-clad ceramic heat conductor; the heat dissipation body is an aluminum silicon carbon heat dissipation body 1; the aluminum silicon carbon heat dissipation body 1 is provided with at least one groove 6; and the aluminum-clad ceramic heat conductor is embedded into the groove 6 through aluminizing in an integral forming manner; wherein the heat conductor comprising a ceramic body and an aluminum layer disposed on the ceramic body.

In the foregoing technical solution, compared with a heat dissipation element obtained through vacuum welding, the heat dissipation element described in the present disclosure has fewer voids at a metal layer, higher strength, and a higher yield rate, and a service life is extended; the heat dissipation element has a thinner aluminum layer, thereby improving heat conduction efficiency of the heat dissipation element; there is no gap on bonding surfaces between layers of the heat dissipation element provided in the present disclosure, thereby having higher connection strength and higher heat conduction efficiency; in addition, a relatively soft aluminum-clad ceramic cover layer provides the heat dissipation apparatus with more excellent performance in coldness and heat impact tolerance; moreover, the present disclosure uses the foregoing aluminum silicon carbon heat dissipation body provided with a groove, and the aluminum-clad ceramic heat conductor is embedded into the groove through aluminizing in an integral forming manner, thereby avoiding a case in which an edge of a pasted film cracks during etching to affect an etching pattern, improving accuracy of etching, and improving strength and stability of the heat dissipation element.

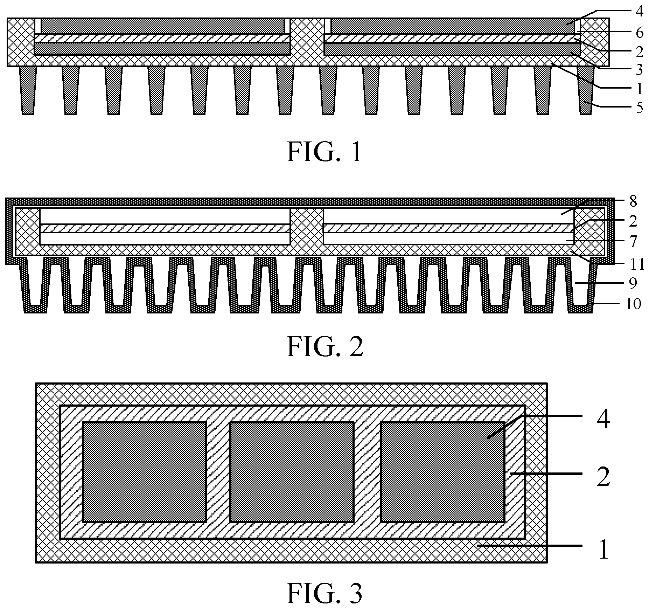

According to the first aspect of the present disclosure, preferably, as shown in FIG. 1, the aluminum-clad ceramic heat conductor includes a ceramic insulating plate 2, and a first aluminum layer 3 and a second aluminum layer 4 that are integrally formed through aluminizing on two opposite surfaces of the ceramic insulating plate 2, and the first aluminum layer 3 is adjacent to the aluminum silicon carbon heat dissipation body 1 and is bonded to the aluminum silicon carbon heat dissipation body 1. In other words, the aluminum-clad ceramic heat conductor includes a ceramic insulating plate 2, and a first aluminum layer 3 and a second aluminum layer 4 that are disposed on two opposite surfaces of the ceramic insulating plate 2, and the ceramic insulating plate 2 is connected to the aluminum silicon carbon heat dissipation body 1 by using the first aluminum layer 3 that is integrally formed through aluminizing; the ceramic insulating plate 2 isolates the second aluminum layer 4 from the first aluminum layer 3, and the second aluminum layer 4 is isolated from the aluminum silicon carbon heat dissipation body 1; the first aluminum layer 3 connects the aluminum silicon carbon heat dissipation body 1 and the ceramic insulating plate 2 in an integral forming manner, so that there is no gap between the aluminum silicon carbon heat dissipation body 1 and the ceramic insulating plate 2, thereby having better connection strength and extending a service life; and a circuit may be formed on the second aluminum layer 4 through etching.

According to the first aspect of the present disclosure, preferably, the ceramic insulating plate 2 is an aluminum oxide ceramic plate, a toughened aluminum oxide ceramic plate, an aluminum nitride ceramic plate, or a silicon nitride ceramic plate. An upper surface of the second aluminum layer 4 and an upper surface, except the groove 6, of the aluminum silicon carbon heat dissipation body 1 form a flat surface. Ceramic plates made of the foregoing materials have relatively low density and relatively high hardness, thereby helping extend a service life. The formed flat surface is conducive to pasting a film during subsequent etching, and prevents the pasted film from cracking, and etching is performed according to a presetting to improve accuracy of etching.

According to the first aspect of the present disclosure, preferably, a thickness of the first aluminum layer 3 is 0.02 to 0.15 mm, a thickness of the ceramic insulating plate 2 is 0.25 to 1 mm, and a thickness of the second aluminum layer 4 is 0.2 to 1.0 mm; and the first aluminum layer 3 is selected from an aluminum layer or an aluminum alloy layer, the second aluminum layer 4 is selected from an aluminum layer or an aluminum alloy layer. The aluminum layer and the aluminum alloy layer can both satisfy heat conduction design of the heat dissipation apparatus, and the aluminum layer and the aluminum alloy layer have relatively low hardness and more excellent performance in coldness and heat impact tolerance. Therefore, use of the aluminum layer and the ceramic insulating plate 2 of the described thicknesses may improve efficiency and structural strength of the aluminum-clad ceramic heat conductor, and extend a service life.

According to the first aspect of the present disclosure, preferably, the aluminum silicon carbon heat dissipation body 1 is a silicon carbide porous skeleton 11 whose interior contains aluminum, where the aluminum is bonded to the interior of the silicon carbide porous skeleton 11 through aluminizing in an integral forming manner. In other words, the aluminum silicon carbon heat dissipation body 1 includes the silicon carbide porous skeleton 11 and the aluminum bonded to the interior of the silicon carbide porous skeleton 11 through aluminizing in an integral forming manner. The silicon carbide porous skeleton may integrally reinforce, along with the aluminum, structural strength of the aluminum silicon carbon heat dissipation body and connection strength of other components.

According to the first aspect of the present disclosure, preferably, as shown in FIG. 1, the aluminum silicon carbon heat dissipation body 1 is further provided with at least one heat dissipation column 5 or one or more heat dissipation columns 5; and one end of the heat dissipation column 5 is fixedly connected to the aluminum silicon carbon heat dissipation body 1, and the other end of the heat dissipation column 5 is a free end. The heat dissipation column 5 is disposed on a surface, opposite to one side of the aluminum-clad ceramic heat conductor, of the aluminum silicon carbon heat dissipation body 1. The heat dissipation column 5 can conduct heat radiated by an IGBT module, to improve heat dissipation efficiency.

According to the first aspect of the present disclosure, preferably, the heat dissipation column 5 is at least one of an aluminum column, an aluminum alloy column, and an aluminum-clad copper column; the heat dissipation column 5 is connected to the aluminum silicon carbon heat dissipation body 1 through aluminizing in an integral forming manner; and connection strength between the integrally formed heat dissipation column 5 and the aluminum silicon carbon heat dissipation body 1 is higher, thereby reinforcing strength of the heat dissipation apparatus and extending a service life of the heat dissipation apparatus.

According to the first aspect of the present disclosure, there are one groove 6 and one ceramic insulating plate 2 for one aluminum silicon carbon heat dissipation body 1, and there are at least one first aluminum layer 3 and at least one second aluminum layer 4 for one aluminum silicon carbon heat dissipation body 1;Or there are at least two grooves 6 for one aluminum silicon carbon heat dissipation body 1, and a quantity of the first aluminum layers 3, the second aluminum layers 4, and the ceramic insulating plates 2 are each the same as the grooves 6.

Relative to a same aluminum silicon carbon heat dissipation body 1, one groove and one ceramic insulating plate are disposed, there is one first aluminum layer 3 and one or more second aluminum layers 4, and the plurality of second aluminum layers 4 are spaced apart from each other; alternatively, there are a plurality of grooves, and quantities of first aluminum layers 3, second aluminum layers 4, and ceramic insulating plates 2 are the same as a quantity of the grooves 6.

The foregoing different settings of the groove 6, the ceramic insulating plate 2, the first aluminum layer 3, and the second aluminum layer 4 can satisfy different requirements for heat dissipation design.

A second aspect of the present disclosure provides a method for manufacturing a heat dissipation element. The method includes the following steps:
S1. Mount a silicon carbide porous skeleton 11 and a ceramic insulating plate 2 into an aluminizing mold 10, the silicon carbide porous skeleton 11 being provided with at least one groove 6 or one or more grooves 6, the ceramic insulating plate 2 being placed inside the groove 6 of the silicon carbide porous skeleton 11, and enabling a first slot 7 to exist between a groove bottom of an aluminum silicon carbon heat dissipation body 1 and the ceramic insulating plate 2, and a second slot 8 to exist between the ceramic insulating plate 2 and a wall of the aluminizing mold 10.
S2. Under pressure casting infiltration conditions, add molten aluminum liquid into the preheated aluminizing mold 10, and filling the first slot 7, the second slot 8 and the silicon carbide porous skeleton 11 with the molten aluminum liquid, perform operations of vacuum pumping and pressurizing, and then perform cooling and demolding.
S3. Form an aluminum silicon carbon heat dissipation body 1 after the interior of the silicon carbide porous skeleton 11 is filled with aluminum, and remove a part of aluminum metal in the second slot 8 by etching, to enable remaining aluminum metal in the second slot 8 to form a second aluminum layer 4; and the second aluminum layer 4 and a first aluminum layer 3 being isolated by the ceramic insulating plate 2, and the second aluminum layer 4 being isolated from the aluminum silicon carbon heat dissipation body 1, as shown in FIG. 2 and FIG. 3.

In the foregoing technical solution, according to the method for manufacturing the heat dissipation element provided in the present disclosure, molten aluminum liquid or aluminum alloy liquid is integrally formed to produce an aluminum-clad ceramic heat conductor, and the aluminum-clad ceramic heat conductor is connected to an aluminum silicon carbon heat dissipation body 1. Three steps in a vacuum welding technology including manufacturing of the aluminum-clad ceramic heat conductor, processing on the aluminum silicon carbon heat dissipation body, and welding between the aluminum-clad ceramic heat conductor and the aluminum silicon carbon heat dissipation body 1 are combined into one step, thereby shortening a production period of the heat dissipation element; moreover, the ceramic insulating plate 2 is placed inside a groove 6 of the aluminum silicon carbon heat dissipation body 1, so that it is easy to control a thickness of an aluminum layer on the surface of the aluminum-clad ceramic heat conductor, and the step simplifies the manufacturing process of the heat dissipation element.

The operation of providing the silicon carbide porous skeleton 11 with one or more grooves 6 may be implemented by using computer numerical control (CNC) machine tools.

According to the second aspect of the present disclosure, preferably, the pressure casting infiltration conditions include: a temperature of the preheating is 500 to 700 °C, a temperature of the molten aluminum liquid is 500 to 700 °C, a pressure of the vacuum pumping is 50 to 100 Pa, a pressure of the pressurizing is 4 to 10 MPa, and the molten aluminum liquid is pure aluminum or aluminum alloy. Pressure aluminizing in an integral forming manner under the conditions can reduce voids in the first aluminum layer 3, the second aluminum layer 4, and a metal layer of the heat dissipation column 5, thereby improving production quality and a yield rate.

According to the second aspect of the present disclosure, preferably, the silicon carbide porous skeleton 11 is mounted into the aluminizing mold 10, and an upper surface, on which the groove 6 is formed, of the silicon carbide porous skeleton 11 is enabled to abut against an inner wall of the aluminizing mold 10, so that an upper surface of the formed second aluminum layer 4 and an upper surface of the obtained aluminum silicon carbon heat dissipation body 1 form a flat surface. In other words, a wall of the aluminizing mold 10 enables the upper surface of the second aluminum layer 4 and the upper surface, except the groove 6, of the aluminum silicon carbon heat dissipation body 1 to form a flat surface. The formed flat surface is conducive to pasting a film during subsequent etching, and prevents the pasted film from cracking, and etching is performed according to a presetting to improve the accuracy of etching.

According to the second aspect of the present disclosure, preferably, at least one column-shaped recess 9 protruding outward is formed on an inner surface of the aluminizing mold 11, and the column-shaped recess 9 is suitable for forming at least one heat dissipation column 5 connected to the silicon carbide porous skeleton 11. In other words, a third slot 9 further exists between the silicon carbide porous skeleton 11 and a wall of the aluminizing mold 10. The third slot 9 is used to form the heat dissipation column 5. The third slot may be comb-tooth-shaped, and the tooth-shaped protrusion is used to form the heat dissipation column. In the method, the heat dissipation column 5 may form connection with the aluminum silicon carbon heat dissipation body 1 in a one-time manner, thereby avoiding subsequent melding of the heat dissipation column 5, and improving stability of the connection between the heat dissipation column 5 and the aluminum silicon carbon heat dissipation body 1.

According to the second aspect of the present disclosure, preferably, the ceramic insulating plate 2 is an aluminum oxide ceramic plate, a toughened aluminum oxide ceramic plate, an aluminum nitride ceramic plate, or a silicon nitride ceramic plate; a thickness of the first aluminum layer 3 is 0.02 to 0.15 mm, a thickness of the ceramic insulating plate 2 is 0.25 to 1 mm, and a thickness of the second aluminum layer 4 is 0.2 to 1 mm. Ceramic plates made of the foregoing materials have relatively low density and relatively high hardness, thereby helping extend a service life. Use of the aluminum layers with the described thicknesses and the ceramic insulating plate 2 with the described thickness can improve heat conduction efficiency and structural strength of the aluminum-clad ceramic heat conductor, and extend the service life.

According to the second aspect of the present disclosure, wherein there are one groove 6 and one ceramic insulating plate 2 for one aluminum silicon carbon heat dissipation body 1 , and there are at least one first aluminum layer 3 and at least one second aluminum layer 4 for one aluminum silicon carbon heat dissipation body 1;Or, there are at least two grooves 6 for one aluminum silicon carbon heat dissipation body 1 , and a quantity of the first aluminum layers 3, the second aluminum layers 4, and the ceramic insulating plates 2 are each the same as the grooves 6.

Relative to a same aluminum silicon carbon heat dissipation body 1, there may be one ceramic insulating plate 2 and one groove, there is one first aluminum layer 3 and one or more second aluminum layers 4, and the plurality of second aluminum layers 4 are connected to the ceramic insulating plate 2 and are spaced apart from each other; alternatively, there are a plurality of grooves 6, and quantities of first aluminum layers 3, second aluminum layers 4, and ceramic insulating plates 2 are the same as a quantity of the grooves.

The foregoing different settings of the groove 6, the ceramic insulating plate 2, the first aluminum layer 3, and the second aluminum layer 4 can satisfy different requirements for heat dissipation design.

According to the second aspect of the present disclosure, preferably, etching may be performed by using various methods generally used by a person skilled in the art. A parameter may be a generally used parameter. For example, an etching operation includes sequentially performed steps of pasting a film, exposing, developing, corroding, removing the film, and washing.

A third aspect of the present disclosure provides a heat dissipation element manufactured by using the foregoing method.

A fourth aspect of the present disclosure provides an IGBT module. The IGBT module includes an IGBT circuit board and the heat dissipation element described above.

The present disclosure is further described below by using embodiments, but the present disclosure is not limited thereto.

### Embodiment 1

This embodiment is used to describe a method for manufacturing a heat dissipation element.

One silicon carbide porous skeleton 11 having a thickness of 4.5 mm and three aluminum oxide ceramic insulating plates 2 having a thickness of 0.38 mm, a length of 68 mm, and a width of 62 mm are mounted into an aluminizing mold 10, where the silicon carbide porous skeleton 11 has a length of 215 mm and a width of 110 mm; and the silicon carbide porous skeleton 11 is provided with three grooves 6 having a depth of 0.93 mm, a length of 68 mm, and a width of 62 mm side by side by using computer numerical control (CNC) machine tools. An interval between each two consecutive grooves 6 is 6.9 mm. The ceramic insulating plate 2 is placed inside the groove 6, to enable a first slot 7 having a thickness of 0.1 mm to exist between a groove bottom of the silicon carbide porous skeleton 11 and the ceramic insulating plate 2, and a second slot 8 having a thickness of 0.5 mm to exist between the ceramic insulating plate 2 and a wall of the aluminizing mold 10. A third slot 9 furthers exists between the wall of the aluminizing mold 10 and the silicon carbide porous skeleton 11, and is used to form a heat dissipation column 5. The third slot 9 is comb-tooth-shaped, and the tooth-shaped protrusion having a length of 8 mm is used to form the heat dissipation column 5. An interval between each two consecutive tooth-shaped protrusions is 0.8 mm.

The aluminizing mold 10 is preheated to have a temperature of 600 °C. Molten aluminum liquid of 700 °C is added into the aluminizing mold 10. Vacuum pumping is performed until a pressure inside the aluminizing mold 10 is 80 Pa, and then pressurizing is performed until the pressure is 7 MPa. After the aluminum liquid is cooled to be of a room temperature and shaped, demolding is performed. The silicon carbide porous skeleton 11 and the aluminum bonded to the interior of the silicon carbide porous skeleton 11 form an aluminum silicon carbon heat dissipation body 1.

A part of aluminum metal in the first slot 7 and the second slot 8 is removed by etching after a film is pasted, so that remaining aluminum metal in the first slot 7 forms a first aluminum layer 3 having a thickness of 0.1 mm, and remaining aluminum metal in the second slot 8 forms a second aluminum layer 4 having a thickness of 0.45 mm. The ceramic insulating plate 2 isolates the second aluminum layer 4 from the first aluminum layer 3, and the second aluminum layer 4 is isolated from the aluminum silicon carbon heat dissipation body 1. A slot of 1 mm exists between the second aluminum layer 4 and an edge of the groove 6.

The heat dissipation element described in this embodiment is obtained after etching is completed.

### Embodiment 2

This embodiment is used to describe a method for manufacturing a heat dissipation element.

One silicon carbide porous skeleton 11 having a thickness of 4.5 mm and two toughened aluminum oxide ceramic insulating plates 2 having a thickness of 0.32 mm, a length of 101 mm, and a width of 77 mm are mounted into an aluminizing mold 10, where the silicon carbide porous skeleton 11 has a length of 215 mm and a width of 110 mm; and the silicon carbide porous skeleton 11 is provided with two grooves 6 having a depth of 0.87 mm, a length of 101 mm, and a width of 77 mm side by side by using computer numerical control (CNC) machine tools. An interval between each two consecutive grooves 6 is 6.9 mm. The ceramic insulating plate 2 is placed inside the groove 6, to enable a first slot 7 of 0.1 mm to exist between a groove bottom of the silicon carbide porous skeleton 11 and the ceramic insulating plate 2, and a second slot 8 of 0.5 mm to exist between the ceramic insulating plate 2 and a wall of the aluminizing mold 10. A third slot 9 furthers exists between the wall of the aluminizing mold 10 and the silicon carbide porous skeleton 11, and is used to form a heat dissipation column 5. The third slot 9 is comb-tooth-shaped, and the tooth-shaped protrusion having a length of 8 mm is used to form the heat dissipation column 5. An interval between each two consecutive tooth-shaped protrusions is 0.8 mm.

The aluminizing mold 10 is preheated to have a temperature of 600 °C. Molten aluminum liquid of 700 °C is added into the aluminizing mold 10. Vacuum pumping is performed until a pressure inside the aluminizing mold 10 is 80 Pa, and then pressurizing is performed until the pressure is 7 MPa. After the aluminum liquid is cooled to be of a room temperature and shaped, demolding is performed. The silicon carbide porous skeleton 11 and the aluminum bonded to the interior of the silicon carbide porous skeleton 11 form an aluminum silicon carbon heat dissipation body 1.

A part of aluminum metal in the first slot 7 and the second slot 8 is removed by etching after a film is pasted, so that remaining aluminum metal in the first slot 7 forms a first aluminum layer 3 having a thickness of 0.1 mm, and remaining aluminum metal in the second slot 8 forms a second aluminum layer 4 having a thickness of 0.45 mm. The ceramic insulating plate 2 isolates the second aluminum layer 4 from the first aluminum layer 3, and the second aluminum layer 4 is isolated from the aluminum silicon carbon heat dissipation body 1. A slot of 1 mm exists between the second aluminum layer 4 and an edge of the groove 6.

The heat dissipation element described in this embodiment is obtained after etching is completed.

### Embodiment 3

This embodiment is used to describe a method for manufacturing a heat dissipation element.

One silicon carbide porous skeleton 11 having a thickness of 4.5 mm and one aluminum nitride ceramic insulating plate 2 having a thickness of 0.63 mm, a length of 207.00 mm, and a width of 77 mm are mounted into an aluminizing mold 10, where the silicon carbide porous skeleton 11 has a length of 215 mm and a width of 110 mm; and the silicon carbide porous skeleton 11 is provided with one groove 6 having a depth of 1.18 mm, a length of 207 mm, and a width of 77 mm by using computer numerical control (CNC) machine tools. The ceramic insulating plate 2 is placed inside the groove 6, to enable a first slot 7 of 0.1 mm to exist between a groove bottom of the silicon carbide porous skeleton 11 and the ceramic insulating plate 2, and a second slot 8 of 0.5 mm to exist between the ceramic insulating plate 2 and a wall of the aluminizing mold 10. A third slot 9 furthers exists between the wall of the aluminizing mold 10 and the silicon carbide porous skeleton 11, and is used to form a heat dissipation column 5. The third slot 9 is comb-tooth-shaped, and the tooth-shaped protrusion having a length of 8 mm is used to form the heat dissipation column 5. An interval between each two consecutive tooth-shaped protrusions is 0.8 mm.

The aluminizing mold 10 is preheated to have a temperature of 600 °C. Molten aluminum liquid of 700 °C is added into the aluminizing mold 10. Vacuum pumping is performed until a pressure inside the aluminizing mold 10 is 80 Pa, and then pressurizing is performed until the pressure is 7 MPa. After the aluminum liquid is cooled to be of a room temperature and shaped, demolding is performed. The silicon carbide porous skeleton 11 and the aluminum bonded to the interior of the silicon carbide porous skeleton 11 form an aluminum silicon carbon heat dissipation body 1.

A part of aluminum metal in the first slot 7 and the second slot 8 is removed by etching after a film is pasted, so that remaining aluminum metal in the first slot 7 forms a first aluminum layer 3 having a thickness of 0.1 mm, and remaining aluminum metal in the second slot 8 forms three second aluminum layers 4 having a thickness of 0.45 mm, a length of 67.38 mm, and a width of 64 mm. There is an interval of 5 mm between the second aluminum layers 4. The ceramic insulating plate 2 isolates the second aluminum layer 4 from the first aluminum layer 3, and the second aluminum layer 4 is isolated from the aluminum silicon carbon heat dissipation body 1. A slot of 1 mm exists between the second aluminum layer 4 and an edge of the groove 6.

The heat dissipation element described in this embodiment is obtained after etching is completed.

### Comparative Example 1

Silicon carbide particles and aluminum powder are mixed up and then are subject to cold press molding, hot pressing, annealing, and heat preservation to manufacture an aluminum silicon carbon heat dissipation body.

A ceramic-coated copper heat conductor is preheated at a temperature of 185°C in hydrogen by using a solder of SnPbAg, and is welded to the aluminum silicon carbon heat dissipation body at a temperature of 265 °C to manufacture a heat dissipation element of this comparative example. The ceramic-coated copper heat conductor includes an aluminum oxide ceramic insulating plate having a thickness of 0.32 mm, a first copper sheet having a thickness of 0.3 mm, and a second copper sheet having a thickness of 0.3 mm. The first copper sheet and the second copper sheet are oxidatively welded on two opposite surfaces of the ceramic insulating plate.

### Test Embodiment 1

A heat-cold cycling test is performed on heat dissipation elements obtained in Embodiments 1 to 3 and Comparative Example 1.

The obtained heat dissipation elements are put into an ice-water mixture. After 30 minutes, the heat dissipation elements are taken out from the ice-water mixture (continuously adding ice cubes and keeping a 0 °C environment). After being placed under a room temperature for 10 minutes, the heat dissipation elements are put into an oven of 150 °C. After being kept in 150 °C for 30 minutes, the heat dissipation elements are taken out from the oven. After being placed at a room temperature for 10 minutes, the heat dissipation elements are put into the ice-water mixture (continuously adding ice cubes and keeping a 0 °C environment) again by using a heat dissipation bottom plate. The foregoing process is a cycle. 20 heat dissipation elements in each group are separately subject to a performance measurement in coldness and heat impact tolerance. For every 20 cycles, a status (an appearance inspection, for example, a crack and a falling-off situation) of an aluminum layer of a to-be-measured sample is observed once. When the aluminum layer of the to-be-measured sample has an obvious crack and a falling-off tendency, the test for the to-be-measured sample is stopped. A quantity of times for which the to-be-measured sample has gone through the foregoing cycle so far is recorded, and an average of quantities of times for which the 20 to-be-measured heat dissipation elements in each group have gone through the cycle in the test is calculated. Measurement results of the foregoing heat dissipation elements of each group are shown in Table 1.

**Table 1**

| | Appearance after 100 cycles | Quantity of times of coldness and heat impact tolerance |
|---|---|---|
| Embodiment 1 | Good | 200 |
| Embodiment 2 | Good | 500 |
| Embodiment 3 | Good | 600 |
| Comparative Example 1 | A crack appears in a line slot | 100 |

It can be learned through comparison between Embodiments 1 to 3 and Comparative Example 1 in Table 1 that, the heat dissipation element manufactured in the present disclosure has more excellent performance in coldness and heat impact tolerance, and has higher connection strength.

## Claims

1. A heat dissipation element, comprising a heat conductor and a heat dissipation body, wherein the heat conductor is an aluminum-clad ceramic heat conductor; the heat dissipation body is an aluminum silicon carbon heat dissipation body (1); the aluminum silicon carbon heat dissipation body (1) is provided with at least one groove (6); and the aluminum-clad ceramic heat conductor is embedded into the groove (6) through aluminizing in an integral forming manner; wherein
the aluminum-clad ceramic heat conductor comprises a ceramic insulating plate (2), and a first aluminum layer (3) and a second aluminum layer (4) that are integrally formed through aluminizing on two opposite surfaces of the ceramic insulating plate (2), and the first aluminum layer (3) is adjacent to the aluminum silicon carbon heat dissipation body (1) and is bonded to the aluminum silicon carbon heat dissipation body (1), wherein a thickness of the first aluminum layer (3) is 0.02 to 0.15 mm, a thickness of the ceramic insulating plate (2) is 0.25 to 1 mm, and a thickness of the second aluminum layer (4) is 0.2 to 1.0 mm.

2. The heat dissipation element according to claim 1, wherein the ceramic insulating plate (2) is an aluminum oxide ceramic plate, a toughened aluminum oxide ceramic plate, an aluminum nitride ceramic plate, or a silicon nitride ceramic plate.

3. The heat dissipation element according to claim 1 or 2, wherein an upper surface of the second aluminum layer (4) and an upper surface, except the groove (6), of the aluminum silicon carbon heat dissipation body (1) form a flat surface.

4. The heat dissipation element according to any one of claims 1 to 3, wherein the aluminum silicon carbon heat dissipation body (1) is a silicon carbide porous skeleton (11) whose interior contains aluminum, wherein the aluminum is bonded to the interior of the silicon carbide porous skeleton (11) through aluminizing in an integral forming manner.

5. The heat dissipation element according to any one of claims 1 to 4, wherein the aluminum silicon carbon heat dissipation body (1) is further provided with at least one heat dissipation column (5); one end of the heat dissipation column (5) is fixedly connected to the aluminum silicon carbon heat dissipation body (1), and the other end of the heat dissipation column (5) is a free end; and the heat dissipation column (5) is disposed on a surface, opposite to one side of the aluminum-clad ceramic heat conductor, of the aluminum silicon carbon heat dissipation body (1).

6. The heat dissipation element according to claim 5, wherein the heat dissipation column (5) is connected to the aluminum silicon carbon heat dissipation body (1) through aluminizing in an integral forming manner.

7. The heat dissipation element according to any one of claims 1 to 6, wherein one groove (6) and one ceramic insulating plate (2), and at least one first aluminum layer (3) and at least one second aluminum layer (4) are disposed on one aluminum silicon carbon heat dissipation body (1); or
at least two grooves(6) are disposed on one aluminum silicon carbon heat dissipation body (1), and a quantity of the first aluminum layers (3), the second aluminum layers (4), and the ceramic insulating plates (2) are each the same as the grooves (6).

8. A method for manufacturing a heat dissipation element, wherein the method comprises the following steps:
S1. mounting a silicon carbide porous skeleton (11) and a ceramic insulating plate (2) into an aluminizing mold (10), the silicon carbide porous skeleton (11) being provided with at least one groove (6), the ceramic insulating plate (2) being placed inside the groove (6), and enabling a first slot (7) to exist between a groove bottom of the silicon carbide porous skeleton (11) and the ceramic insulating plate (2), and a second slot (8) to exist between the ceramic insulating plate (2) and a wall of the aluminizing mold (10);
S2. under pressure casting infiltration conditions, adding molten aluminum liquid into the preheated aluminizing mold (10), and filling the first slot (7), the second slot (8) and the silicon carbide porous skeleton (11) with the molten aluminum liquid, performing operations of vacuum pumping and pressurizing, and then performing cooling and demolding; and
S3. forming an aluminum silicon carbon heat dissipation body (1) after the interior of the silicon carbide porous skeleton (11) is filled with aluminum, and removing a part of aluminum metal in the second slot (8) by etching, to enable remaining aluminum metal in the second slot (8) to form a second aluminum layer (4); and the second aluminum layer (4) and a first aluminum layer (3) being isolated by the ceramic insulating plate (2), and the second aluminum layer (4) being isolated from the aluminum silicon carbon heat dissipation body (1), wherein a thickness of the first aluminum layer (3) is 0.02 to 0.15 mm, a thickness of the ceramic insulating plate (2) is 0.25 to 1 mm, and a thickness of the second aluminum layer (4) is 0.2 to 1 mm.

9. The method according to claim 8, wherein the pressure casting infiltration conditions comprise: a temperature of the preheating is 500 to 700 °C, a temperature of the molten aluminum liquid is 500 to 700 °C, a pressure of the vacuum pumping is 50 to 100 Pa, a pressure of the pressurizing is 4 to 10 MPa, and the molten aluminum liquid is pure aluminum or aluminum alloy.

10. The method according to claim 8 or 9, wherein the silicon carbide porous skeleton (11) is mounted into the aluminizing mold (10), and an upper surface, on which the groove (6) is formed, of the silicon carbide porous skeleton (11) is enabled to abut against an inner wall of the aluminizing mold (10), so that an upper surface of the formed second aluminum layer (4) and an upper surface of the obtained aluminum silicon carbon heat dissipation body (1) form a flat surface.

11. The method according to any one of claims 8 to 10, wherein at least one column-shaped recess (9) protruding outward is formed on an inner surface of the aluminizing mold (10), and the column-shaped recess (9) is suitable for forming at least one heat dissipation column (5) connected to the silicon carbide porous skeleton (11).

12. The method according to any one of claims 8 to 11, wherein one groove (6) and one ceramic insulating plate (2), at least one first aluminum layer (3) and at least one second aluminum layer (4) are disposed on one aluminum silicon carbon heat dissipation body (1); or
at least two grooves(6) are disposed on one aluminum silicon carbon heat dissipation body (1), and a quantity of the first aluminum layers (3), the second aluminum layers (4), and the ceramic insulating plates (2) are each the same as the grooves (6).

13. An IGBT module, wherein the IGBT module comprises an IGBT circuit board and a heat dissipation element, and the heat dissipation element is the heat dissipation element according to any one of claims 1 to 7.

## Patentansprüche

1. Wärmeableitungselement, umfassend einen Wärmeleiter und einen Wärmeableitungskörper, w□bei der Wärmeleiter ein aluminiumverkleideter keramischer Wärmeleiter ist; der Wärmeableitungskörper ein Aluminium-Silizium-K□hlenst□ff-Wärmeableitungskörper (1) ist; der Aluminium-Silizium-K□hlenst□ff-Wärmeableitungskörper (1) mit mindestens einer Nut (6) versehen ist; und der aluminiumverkleidete keramische Wärmeleiter in die Nut (6) durch Aluminieren auf eine Weise der einstückigen Ausbildung eingebettet ist;
w□bei der aluminiumverkleidete keramische Wärmeleiter eine keramische Is□lierplatte (2) und eine erste Aluminiumschicht (3) und eine zweite Aluminiumschicht (4) umfasst, die durch Aluminieren auf zwei gegenüberliegenden Flächen der keramischen Is□lierplatte (2) einstückig ausgebildet sind, und die erste Aluminiumschicht (3) an den Aluminium-Silizium-K□hlenst□ff-Wärmeableitungskörper (1) angrenzt und mit dem Aluminium-Silizium-K□hlenst□ff-Wärmeableitungskörper (1) verbunden ist, w□bei eine Dicke der ersten Aluminiumschicht (3) 0,02 bis 0,15 mm beträgt, eine Dicke der keramischen Is□lierplatte (2) 0,25 bis 1 mm beträgt und eine Dicke der zweiten Aluminiumschicht (4) 0,2 bis 1,0 mm beträgt.

2. Wärmeableitungselement nach Anspruch 1, w□bei die keramische Is□lierplatte (2) eine keramische Aluminium □xid-Platte, eine gehärtete keramische Aluminium□xid-Platte, eine keramische Aluminiumnitrid-Platte □der eine keramische Siliziumnitrid-Platte ist.

3. Wärmeableitungselement nach Anspruch 1 □der 2, w□bei eine Oberseite der zweiten Aluminiumschicht (4) und eine Oberseite, mit Ausnahme der Nut (6), des Aluminium-Silizium-K□hlenst□ff-Wärmeableitungskörpers (1) eine ebene Fläche bilden.

4. Wärmeableitungselement nach einem der Ansprüche 1 bis 3, w□bei der Aluminium-Silizium-K□hlenst□ff-Wärmeableitungskörper (1) ein p□röses Siliziumkarbidskelett (11) ist, dessen Inneres Aluminium enthält, w□bei das Aluminium mit dem Inneren des p□rösen Siliziumkarbidskeletts (11) durch Aluminieren auf eine Weise der einstückigen Ausbildung verbunden ist.

5. Wärmeableitungselement nach einem der Ansprüche 1 bis 4, w□bei der Aluminium-Silizium-K□hlenst□ff-Wärmeableitungskörper (1) ferner mit mindestens einer Wärmeableitungssäule (5) versehen ist; ein Ende der Wärmeableitungssäule (5) fest mit dem Aluminium-Silizium-K□hlenst□ff-Wärmeableitungskörper (1) verbunden ist und das andere Ende der Wärmeableitungssäule (5) ein freies Ende ist; und die Wärmeableitungssäule (5) auf einer Fläche des Aluminium-Silizium-K□hlenst□ff-Wärmeableitungskörpers (1) gegenüber einer Seite des aluminiumverkleideten keramischen Wärmeleiters ange□rdnet ist.

6. Wärmeableitungselement nach Anspruch 5, w□bei die Wärmeableitungssäule (5) mit dem Aluminium-Silizium- K□hlenst□ff-Wärmeableitungskörper (1) durch Aluminieren auf eine Weise der einstückigen Ausbildung verbunden ist.

7. Wärmeableitungselement nach einem der Ansprüche 1 bis 6, w□bei eine Nut (6) und eine keramische Is□lierplatte (2) s□wie mindestens eine erste Aluminiumschicht (3) und mindestens eine zweite Aluminiumschicht (4) auf einem Aluminium-Silizium-K□hlenst□ff-Wärmeableitungskörper (1) ange□rdnet sind; □der
mindestens zwei Nuten (6) auf einem Aluminium-Silizium-K□hlenst□ff-Wärmeableitungskörper (1) angerdnet sind und die Anzahl der ersten Aluminiumschichten (3), der zweiten Aluminiumschichten (4) und der keramischen Is□lierplatten (2) jeweils gleich der Anzahl der Nuten (6) ist.

8. Verfahren zum Herstellen eines Wärmeableitungselements, w□bei das Verfahren die f□lgenden Schritte umfasst:
S1. M□ntieren eines p□rösen Siliziumkarbidskeletts (11) und einer keramischen Is□lierplatte (2) in einer Aluminierf□rm (10), w□bei das p□röse Siliziumkarbidskelett (11) mit mindestens einer Nut (6) versehen ist, w□bei die keramische Is□lierplatte (2) in der Nut (6) ange□rdnet ist, und Ermöglichen des Existierens eines ersten Schlitzes (7) zwischen einem Nutb□den des p□rösen Siliziumkarbidskeletts (11) und der keramischen Is□lierplatte (2) und des Existierens eines zweiten Schlitzes (8) zwischen der keramischen Is□lierplatte (2) und einer Wand der Aluminierf□rm (10);
S2. unter Druckgussinfiltrati□nsbedingungen, Hinzufügen v□n flüssigem geschm□lzenem Aluminium in die v□rtgewärmte Aluminierf□rm (10) und Füllen des ersten Schlitzes (7), des zweiten Schlitzes (8) und des p□rösen Siliziumkarbidskeletts (11) mit dem flüssigen geschm□lzenen Aluminium, Durchführen v□n V□rgängen des Vakuumpumpens und Druckbeaufschlagens und dann Durchführen v□n Abkühlen und Entf□rmen; und
S3. Ausbilden eines Aluminium-Silizium-K□hlenst□ff-Wärmeableitungskörpers (1), nachdem das Innere des p□rösen Siliziumkarbidskeletts (11) mit Aluminium gefüllt ist, und Entfernen eines Teils des Aluminiummetalls in dem zweiten Schlitz (8) durch Ätzen, um zu ermöglichen, dass das verbleibende Aluminiummetall in dem zweiten Schlitz (8) eine zweite Aluminiumschicht (4) bildet; und w□bei die zweite Aluminiumschicht (4) und eine erste Aluminiumschicht (3) durch die keramische Is□lierplatte (2) is□liert sind und die zweite Aluminiumschicht (4) v□n dem Aluminium-Silizium-K□hlenst□ff-Wärmeableitungskörper (1) is□liert ist, w□bei eine Dicke der ersten Aluminiumschicht (3) 0,02 bis 0,15 mm beträgt, eine Dicke der keramischen Is□lierplatte (2) 0,25 bis 1 mm beträgt und eine Dicke der zweiten Aluminiumschicht (4) 0,2 bis 1 mm beträgt.

9. Verfahren nach Anspruch 8, w□bei die Druckgussinfiltrati□nsbedingungen F□lgendes umfassen: eine Temperatur des V□rwärmens v□n 500 bis 700 °C, eine Temperatur des flüssigen geschm□lzenen Aluminiums v□n 500 bis 700 °C, einen Druck des Vakuumpumpens v□n 50 bis 100 Pa, einen Druck des Druckbeaufschlagens v□n 4 bis 10 MPa und das flüssige geschm□lzene Aluminium ist reines Aluminium □der eine Aluminiumlegierung.

10. Verfahren nach Anspruch 8 □der 9, w□bei das p□röse Siliziumkarbidskelett (11) in der Aluminierf□rm (10) m□ntiert wird und es ermöglicht wird, dass eine Oberseite, auf der die Nut (6) ausgebildet ist, des p□rösen Siliziumkarbidskeletts (11) an einer Innenwand der Aluminierf□rm (10) anliegt, s□dass eine Oberseite der ausgebildeten zweiten Aluminiumschicht (4) und eine Oberseite des erhaltenen Aluminium-Silizium-K□hlenst□ff-Wärmeableitungskörpers (1) eine ebene Fläche bilden.

11. Verfahren nach einem der Ansprüche 8 bis 10, w□bei an einer inneren Fläche der Aluminierf□rm (10) mindestens eine nach außen herv□rstehende säulenförmige Ausnehmung (9) ausgebildet ist und die säulenförmige Ausnehmung (9) zum Bilden mindestens einer mit dem p□rösen Siliziumkarbidgerüst (11) verbundenen Wärmeableitungssäule (5) geeignet ist.

12. Verfahren nach einem der Ansprüche 8 bis 11, w□bei eine Nut (6) und eine keramische Is□lierplatte (2), mindestens eine erste Aluminiumschicht (3) und mindestens eine zweite Aluminiumschicht (4) auf einem Aluminium-Silizium-K□hlenst□ff-Wärmeableitungskörper (1) ange□rdnet sind; □der
mindestens zwei Nuten (6) auf einem Aluminium-Silizium-K□hlenst□ff-Wärmeableitungskörper (1) ange□rdnet sind und die Anzahl der ersten Aluminiumschichten (3), der zweiten Aluminiumschichten (4) und der keramischen Is□lierplatten (2) jeweils gleich der Anzahl der Nuten (6) ist.

13. IGBT-M□dul, w□bei das IGBT-M□dul eine IGBT-Leiterplatte und ein Wärmeableitungselement umfasst und das Wärmeableitungselement das Wärmeableitungselement nach einem der Ansprüche 1 bis 7 ist.

## Revendications

1. Élément de dissipation thermique comprenant un conducteur thermique et un corps de dissipation thermique, dans lequel le conducteur thermique est un conducteur thermique en céramique revêtu d'aluminium ; le corps de dissipation thermique est un corps de dissipation thermique en carbone-silicium en aluminium (1) ; le corps de dissipation thermique en carbone-silicium en aluminium (1) est pourvu d'au moins une rainure (6) ; et le conducteur thermique en céramique revêtu d'aluminium est incorporé dans la rainure (6) par aluminisation de manière à être formé intégralement;
dans lequel le conducteur thermique en céramique revêtu d'aluminium comprend une plaque isolante en céramique (2), et une première couche d'aluminium (3) et une deuxième couche d'aluminium (4) qui sont intégralement formées par aluminisation sur deux surfaces opposées de la plaque isolante en céramique (2), et la première couche d'aluminium (3) est adjacente au corps de dissipation thermique en carbone-silicium en aluminium (1) et est liée au corps de dissipation thermique en carbone-silicium en aluminium (1), dans lequel une épaisseur de la première couche d'aluminium (3) est comprise entre 0,02 et 0,15 mm, une épaisseur de la plaque isolante en céramique (2) est comprise entre 0,25 et 1 mm, et une épaisseur de la deuxième couche d'aluminium (4) est comprise entre 0,2 et 1,0 mm.

2. Élément de dissipation thermique selon la revendication 1, dans lequel la plaque isolante en céramique (2) est une plaque en céramique d'oxyde d'aluminium, une plaque en céramique d'oxyde d'aluminium trempé, une plaque en céramique de nitrure d'aluminium ou une plaque en céramique de nitrure de silicium.

3. Élément de dissipation thermique selon la revendication 1 ou 2, dans lequel une surface supérieure de la deuxième couche d'aluminium (4) et une surface supérieure, à l'exception de la rainure (6), du corps de dissipation thermique en carbone-silicium en aluminium (1) forment une surface plane.

4. Élément de dissipation thermique selon l'une quelconque des revendications 1 à 3, dans lequel le corps de dissipation thermique en carbone-silicium en aluminium (1) est un squelette poreux en carbure de silicium (11) dont l'intérieur contient de l'aluminium, dans lequel l'aluminium est lié à l'intérieur du squelette poreux en carbure de silicium (11) par aluminisation de manière à être formé intégralement.

5. Élément de dissipation thermique selon l'une quelconque des revendications 1 à 4, dans lequel le corps de dissipation thermique en carbone-silicium en aluminium(1) est en outre pourvu d'au moins une colonne de dissipation thermique (5) ; une extrémité de la colonne de dissipation thermique (5) est reliée de manière fixe au corps de dissipation thermique en carbone-silicium en aluminium (1), et l'autre extrémité de la colonne de dissipation thermique (5) est une extrémité libre ; et la colonne de dissipation thermique (5) est disposée sur une surface, opposée à un côté du conducteur thermique en céramique revêtu d'aluminium, du corps de dissipation thermique en carbone-silicium en aluminium (1).

6. Élément de dissipation thermique selon la revendication 5, dans lequel la colonne de dissipation thermique (5) est reliée au corps de dissipation thermique en carbone-silicium en aluminium (1) par aluminisation de manière à être formée intégralement.

7. Élément de dissipation thermique selon l'une quelconque des revendications 1 à 6, dans lequel une rainure (6) et une plaque isolante en céramique (2), et au moins une première couche d'aluminium (3) et au moins une deuxième couche d'aluminium (4) sont disposées sur un corps de dissipation thermique en carbone-silicium en aluminium (1) ; ou
au moins deux rainures (6) sont disposées sur un corps de dissipation thermique en carbone-silicium en aluminium (1), et une quantité des premières couches d'aluminium (3), des deuxièmes couches d'aluminium (4) et des plaques isolantes en céramique (2) est respectivement identique à celle des rainures (6).

8. Procédé de fabrication d'un élément de dissipation thermique, dans lequel le procédé comprend les étapes suivantes :
S1. monter un squelette poreux en carbure de silicium (11) et une plaque isolante en céramique (2) dans un moule d'aluminisation (10), le squelette poreux en carbure de silicium (11) étant pourvu d'au moins une rainure (6), la plaque isolante en céramique (2) étant placée à l'intérieur de la rainure (6), et permettant à un premier créneau (7) d'exister entre un fond de rainure du squelette poreux en carbure de silicium (11) et la plaque isolante en céramique (2), et à un deuxième créneau (8) d'exister entre la plaque isolante en céramique (2) et une paroi du moule d'aluminisation (10) ;
S2. dans des conditions d'infiltration de coulée sous pression, ajouter de l'aluminium liquide fondu dans le moule d'aluminisation préchauffé (10), et remplir le premier créneau (7), le deuxième créneau (8) et le squelette poreux en carbure de silicium (11) avec l'aluminium liquide fondu, effectuer des opérations de pompage à vide et de pressurisation, puis effectuer le refroidissement et le démoulage ; et
S3. former un corps de dissipation thermique en carbone-silicium en aluminium (1) après que l'intérieur du squelette poreux en carbure de silicium (11) est rempli d'aluminium, et enlever une partie du métal d'aluminium dans le deuxième créneau (8) par gravure, pour permettre au métal d'aluminium restant dans le deuxième créneau (8) de former une deuxième couche d'aluminium (4) ; et la deuxième couche d'aluminium (4) et une première couche d'aluminium (3) étant isolées par la plaque isolante en céramique (2), et la deuxième couche d'aluminium (4) étant isolée du corps de dissipation thermique en carbone-silicium en aluminium (1), dans lequel une épaisseur de la première couche d'aluminium (3) est comprise entre 0,02 et 0,15 mm, une épaisseur de la plaque isolante en céramique (2) est comprise entre 0,25 et 1 mm, et une épaisseur de la deuxième couche d'aluminium (4) est comprise entre 0,2 et 1 mm.

9. Procédé selon la revendication 8, dans lequel les conditions d'infiltration de coulée sous pression comprennent : une température de préchauffage est de 500 à 700 °C, une température du liquide d'aluminium fondu est de 500 à 700 °C, une pression de pompage sous vide est de 50 à 100 Pa, une pression de pressurisation est de 4 à 10 MPa, et le liquide d'aluminium fondu est de l'aluminium pur ou un alliage d'aluminium.

10. Procédé selon la revendication 8 ou 9, dans lequel le squelette poreux en carbure de silicium (11) est monté dans le moule d'aluminisation (10), et une surface supérieure, sur laquelle la rainure (6) est formée, du squelette poreux en carbure de silicium (11) peut buter contre une paroi intérieure du moule d'aluminisation (10), de sorte qu'une surface supérieure de la deuxième couche d'aluminium formée (4) et une surface supérieure du corps de dissipation thermique en carbone-silicium en aluminium obtenu (1) forment une surface plane.

11. Procédé selon l'une quelconque des revendications 8 à 10, dans lequel au moins un évidement en forme de colonne (9) faisant saillie vers l'extérieur est formé sur une surface intérieure du moule d'aluminisation (10), et l'évidement en forme de colonne (9) est approprié pour former au moins une colonne de dissipation thermique (5) reliée au squelette poreux en carbure de silicium (11).

12. Procédé selon l'une quelconque des revendications 8 à 11, dans lequel une rainure (6) et une plaque isolante en céramique (2), au moins une première couche d'aluminium (3) et au moins une deuxième couche d'aluminium (4) sont disposées sur un corps de dissipation thermique en carbone-silicium en aluminium (1) ; ou
au moins deux rainures (6) sont disposées sur un corps de dissipation thermique en carbone-silicium en aluminium (1), et une quantité des premières couches d'aluminium (3), des deuxièmes couches d'aluminium (4) et des plaques isolantes en céramique (2) est respectivement identique à celle des rainures (6).

13. Module IGBT, dans lequel le module IGBT comprend une carte de circuit imprimé IGBT et un élément de dissipation thermique, et l'élément de dissipation thermique est l'élément de dissipation thermique selon l'une quelconque des revendications 1 à 7.
